(19) Europäisches Patentamt
European Patent Office
Office européen des brevets

(11) **EP 2 327 158 B1**

(12) **FASCICULE DE BREVET EUROPEEN**

(45) Date de publication et mention
de la délivrance du brevet:
**25.01.2012 Bulletin 2012/04**

(51) Int Cl.:
**H03K 17/94** *(2006.01)*

(21) Numéro de dépôt: **09781016.2**

(22) Date de dépôt: **24.07.2009**

(86) Numéro de dépôt international:
**PCT/EP2009/059540**

(87) Numéro de publication internationale:
**WO 2010/028902 (18.03.2010 Gazette 2010/11)**

(54) **DISPOSITIF DE COMMANDE INCLUANT UN CAPTEUR PHOTOVOLTAIQUE**

EINEN PHOTOVOLTAIKSENSOR ENTHALTENDE STEUERANORDNUNG

CONTROL DEVICE INCLUDING A PHOTOVOLTAIC SENSOR

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **12.09.2008 FR 0856146**

(43) Date de publication de la demande:
**01.06.2011 Bulletin 2011/22**

(73) Titulaire: **Schneider Electric Industries SAS 92500 Rueil-Malmaison (FR)**

(72) Inventeurs:
• **CHAUVET, Francis**
**F-16440 Moutiers (FR)**
• **GUILLOT, Alain**
**F-16730 Fleac (FR)**

(74) Mandataire: **Bié, Nicolas**
**Schneider Electric Industries SAS**
**Service Propriété Industrielle**
**35 rue Joseph Monier - CS 30323**
**92506 Rueil-Malmaison Cedex (FR)**

(56) Documents cités:
**DE-A1- 19 805 959      DE-A1-102007 008 007**
**FR-A- 2 597 682      FR-A- 2 606 912**
**US-A- 5 251 872**

• **KAN S Y ET AL: "The use of battery-capacitor combinations in photovoltaic powered products" JOURNAL OF POWER SOURCES, ELSEVIER, AMSTERDAM, NL, vol. 162, no. 2, 22 novembre 2006 (2006-11-22), pages 971-974, XP025084788 ISSN: 0378-7753 [extrait le 2006-11-22]**

**Description**

La présente invention se rapporte à un dispositif de commande d'un circuit électrique. Ce dispositif présente la particularité de comporter un capteur photovoltaïque permettant notamment de convertir une énergie lumineuse en une énergie électrique.

In est connu du brevet FR 2 606 912 ou FR 2 618 242 un dispositif émetteur autonome utilisant un capteur photovoltaïque permettant de générer une énergie électrique suffisante pour émettre un signal à destination d'un récepteur distant commandant un appareillage électrique. En plus du capteur photovoltaïque, un tel dispositif comporte un bouton-poussoir de commande mécanique actionné pour l'émission du signal à destination du récepteur. L'utilisation d'un bouton de commande mécanique présente deux inconvénients majeurs qui sont la sensibilité à l'usure et un encombrement important.

Le brevet US 5,251,872 décrit pour sa part un dispositif de commande dans lequel un capteur photovoltaïque est employé comme capteur de présence.

Le but de l'invention est de proposer un dispositif de commande d'un circuit électrique qui soit compact, qui puisse être complètement autonome et qui ne soit pas soumis à l'usure de pièces mécaniques et à l'encrassement. Le dispositif de commande de l'invention sera notamment robuste et permettra de détecter à coup sûr la présence d'un doigt et de discriminer la présence d'objets parasites.

Ce but est atteint par un dispositif de commande d'un circuit électrique qui comprend :

- un capteur photovoltaïque pour convertir une énergie lumineuse en une énergie électrique disponible pour le dispositif,

- des moyens de détection pour détecter la présence d'un doigt ou d'un objet sur le dispositif,

- les moyens de détection utilisant le capteur photovoltaïque pour détecter la présence du doigt ou de l'objet sur le dispositif,

- le capteur photovoltaïque comportant au moins une cellule photovoltaïque de détection et deux cellules photovoltaïques de référence.

Selon l'invention, le dispositif détecte la présence d'un doigt ou d'un objet sur sa tête de commande et est donc insensible à la couleur de l'objet ou du doigt. Celui-ci pourra être détecté qu'il soit de couleur claire ou sombre.

Selon une autre particularité, le dispositif comporte un condensateur associé à la cellule photovoltaïque de détection et un condensateur associé à chaque cellule photovoltaïque de référence. Chaque condensateur est monté en parallèle par rapport à sa cellule photovoltaïque respective.

Selon l'invention, le rapport entre la surface de la cellule photovoltaïque de détection et la capacité de son condensateur associé, est égal au rapport entre la surface de chaque cellule photovoltaïque de référence et la capacité de leur condensateur associé.

Selon une autre particularité, le dispositif comporte un condensateur principal destiné à être chargé par chaque condensateur associé à une cellule photovoltaïque.

Selon une autre particularité, le dispositif comporte un convertisseur continu/continu commandé par des moyens de traitement, reliant chaque ensemble constitué d'un condensateur et d'une cellule photovoltaïque au condensateur principal. Au moins deux de ces ensembles sont connectés au convertisseur continu/continu par l'intermédiaire d'un interrupteur commandé par les moyens de traitement.

La cellule photovoltaïque de détection et les deux cellules photovoltaïques de référence sont par exemple agencées sous la forme de trois bandes adjacentes. Les trois bandes sont par exemple disposées sur le dispositif de manière adjacente suivant un axe déterminé perpendiculaire à un plan vertical d'approche du doigt ou de l'objet sur le dispositif. La cellule photovoltaïque de détection est par exemple placée entre les deux cellules photovoltaïques de référence.

Selon l'invention, les surfaces des cellules photovoltaïques sont choisies de manière à ce que lorsque le doigt ou l'objet est posé sur le dispositif, celui-ci recouvre une surface suffisante de la bande formée par la cellule photovoltaïque de détection.

Selon l'invention, le circuit électrique à commander comporte par exemple un émetteur destiné à être alimenté par l'énergie électrique générée grâce au capteur photovoltaïque et apte à communiquer par liaison sans fil avec un récepteur distant.

L'émetteur est par exemple intégré dans le dispositif. Selon l'invention, le circuit électrique comporte par exemple un interrupteur apte à être commandé électriquement par le dispositif.

L'invention concerne également un procédé pour détecter la présence d'un doigt ou d'un objet sur un dispositif de commande d'un circuit électrique tel que défini ci-dessus, ce procédé comportant des étapes successives de :

- après une durée prédéterminée ou variable, mesure des tensions aux bornes des condensateurs associés aux cellules photovoltaïques,

- comparaison des tensions entre elles pour valider ou non la présence d'un doigt sur le dispositif.

Selon une particularité, le procédé comprend également une étape de transfert des charges accumulées dans les condensateurs vers le condensateur principal par activation du convertisseur continu/continu.

Selon une autre particularité, le procédé comprend également une étape de désactivation du convertisseur continu/continu lorsque les tensions aux bornes des condensateurs ont atteint un seuil minimal déterminé.

Selon une autre particularité, la durée variable correspond à une durée au bout de laquelle une tension aux bornes de l'un des condensateurs a atteint un seuil maximal déterminé.

Selon une autre particularité, le seuil minimal et/ou le seuil maximal sont variables en fonction de la détection de l'éclairement général du dispositif.

Selon une autre particularité, si la tension aux bornes du condensateur associé à la cellule photovoltaïque de détection est très inférieure aux deux tensions aux bornes du condensateur associé à chaque cellule photovoltaïque de référence, la présence d'un doigt ou d'un objet est détectée.

D'autres caractéristiques et avantages vont apparaître dans la description détaillée qui suit. Pour cela, il sera fait référence aux dessins annexés définis ci-après :

- la figure 1 représente le dispositif de commande de l'invention,

- les figures 2A à 2D illustrent le principe de fonctionnement du dispositif de l'invention,

- la figure 3 représente un schéma du principe de fonctionnement du dispositif de l'invention,

- la figure 4 représente plusieurs diagrammes montrant l'évolution des tensions aux bornes des condensateurs en fonction de l'état des interrupteurs.

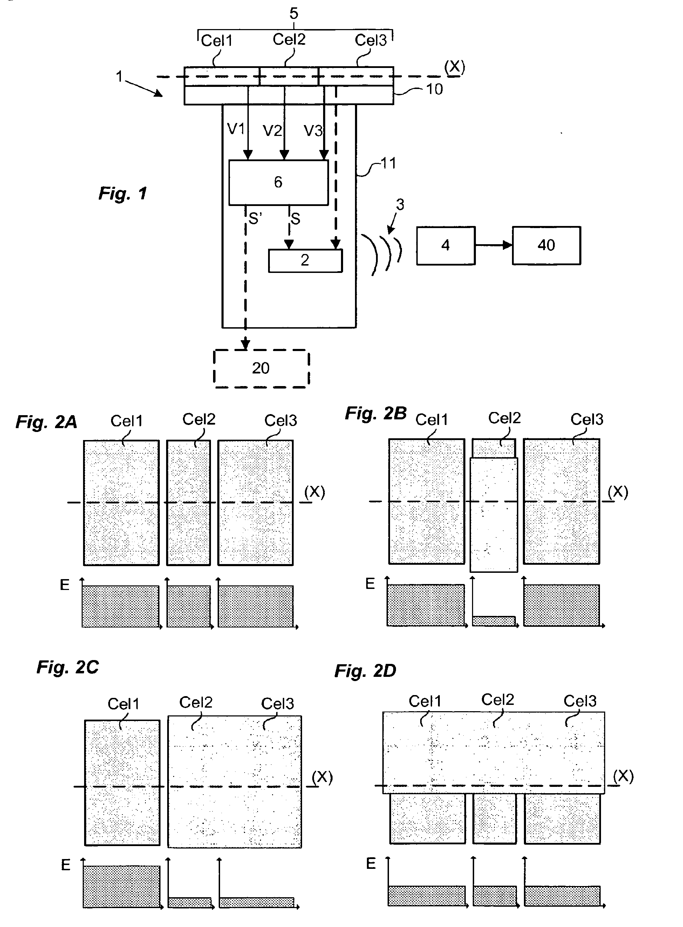

Le dispositif de commande 1 de l'invention représenté en figure 1 prend par exemple la forme d'un bouton poussoir classique. Bien entendu, selon son application, d'autres formes peuvent être imaginées. En référence à la figure 1, le dispositif de commande 1 comporte par exemple une tête de commande 10 prolongée par une partie tubulaire 11.

Le dispositif de commande est destiné à commander un circuit électrique 2, 20 en envoyant un signal électrique de commande S, S' à travers un conducteur électrique. Le circuit électrique à commander peut être inclus dans le dispositif (2 sur la figure 1), par exemple dans sa partie tubulaire 11, ou être extérieur au dispositif (20 sur la figure 1).

Le circuit électrique 2, 20 à commander peut par exemple comporter un interrupteur, tel que par exemple un relais ou un transistor, apte à être commandé par le signal électrique de commande S, S'. Le circuit électrique comporte par exemple un émetteur, préférentiellement inclus dans le dispositif, commandé par le dispositif de commande et apte à communiquer à travers une liaison sans fil 3 avec un récepteur distant 4. Le récepteur 4 peut être destiné par exemple à la commande d'une lampe ou d'une porte 40. La liaison sans fil 3 est par exemple de type radio, infrarouge...

Le dispositif 1 de l'invention présente la particularité de comporter un capteur photovoltaïque 5 composé de plusieurs cellules photovoltaïques. Sur la figure 1, le capteur photovoltaïque 5 est agencé dans la tête de commande 10 du dispositif 1.

De manière connue, une cellule photovoltaïque est un composant électronique, qui, exposé à la lumière (photons), génère de l'énergie électrique, grâce à l'effet photovoltaïque. Les cellules photovoltaïques sont constituées de semi-conducteurs, principalement à base de silicium (Si) (plus rarement d'autres semi-conducteurs : sulfure de cadmium (CdS), tellurure de cadmium (CdTe), etc.). Elles se présentent sous la forme de fines plaques, rondes ou carrées, d'une dizaine de centimètres de coté, prises en sandwich entre deux contacts métalliques, pour une épaisseur de l'ordre du millimètre.

Le capteur photovoltaïque 5 utilisé dans le dispositif de l'invention comporte au moins deux cellules photovoltaïques et préférentiellement, pour plus de robustesse, au moins trois cellules photovoltaïques Cel1, Cel2, Cel3. Chaque cellule photovoltaïque Cel1, Cel2, Cel3 du capteur peut elle-même être composée de plusieurs sous-cellules photovoltaïques, dans un nombre suffisant pour générer la tension destinée à alimenter les circuits électroniques internes du dispositif.

En utilisant l'énergie électrique créée grâce à son capteur photovoltaïque 5, le dispositif 1 peut ainsi être entièrement autonome pour alimenter ses circuits électroniques internes.

Le principe de l'invention consiste à utiliser le capteur photovoltaïque 5 à la fois pour générer une énergie électrique destinée à alimenter les circuits internes du dispositif et pour détecter la présence d'un doigt ou d'un objet sur le dispositif et ainsi commander le circuit électrique 2, 20. Ainsi, selon l'invention on utilise un seul capteur 5 pour l'alimentation du dispositif et pour la détection de l'activation de la commande.

Pour cela le dispositif de l'invention comporte des moyens de détection 6 coopérant avec le capteur photovoltaïque 5 pour détecter la présence du doigt ou de l'objet placé sur la surface de la tête 10 du dispositif 1. Au moins une cellule photovoltaïque du capteur photovoltaïque 5 est utilisée comme cellule photovoltaïque de détection Cel2 tandis que deux autres cellules photovoltaïques du capteur 5 sont utilisées comme cellule photovoltaïque de référence Cel1, Cel3.

Les trois cellules photovoltaïques Cel1, Cel2, Cel3 sont montées en parallèle dans un circuit électrique relié aux moyens de détection. A chaque cellule photovoltaïque est associé un condensateur C1, C2, C3. Les condensateurs C1, C2, C3 sont montés en parallèle de leur cellule photovoltaïque respective.

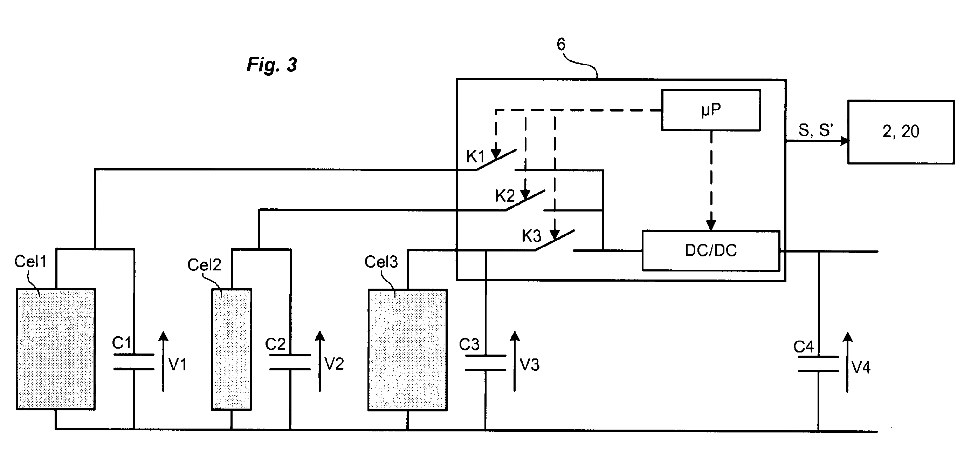

Le dispositif comporte en outre un condensateur principal C4 destiné à stocker l'énergie emmagasinée dans chaque condensateur C1, C2, C3 lorsqu'un transfert de charge est opéré entre les condensateurs C1, C2, C3 et le condensateur principal C4. Un tel transfert de charge est commandé à l'aide d'au moins deux interrupteurs, par exemple trois interrupteurs K1, K2, K3, et d'un convertisseur continu/continu appelé également convertisseur DC/DC. Sur la figure 3, les ensembles constitués chacun d'une cellule photovoltaïque Cel1, Cel2, Cel3 et d'un condensateur en parallèle sont reliés en parallèle au convertisseur continu/continu par l'intermédiaire des interrupteurs K1, K2, K3.

Les moyens de détection 6 d'un doigt ou d'un d'objet sur le dispositif comprennent notamment des moyens de traitement du type microprocesseur µP, le convertisseur continu/continu et les interrupteurs K1, K2, K3 commandés par le microprocesseur µP. L'énergie accumulée dans le condensateur principal C4 sert notamment à alimenter le microprocesseur µP et éventuellement à alimenter le circuit électrique 2, 20 à commander si celui-ci comporte par exemple un émetteur.

Selon l'invention, le rapport entre la surface SurfCel2 de la cellule photovoltaïque de détection Cel2 et la capacité de son condensateur C2 est égal au rapport entre la surface SurfCel1, SurfCel3 de chaque cellule de référence Cel1, Cel3 et la capacité de leur condensateur C1, C3 respectif. Autrement dit, nous avons :

$$\frac{SurfCel1}{C1} = \frac{SurfCel2}{C2} = \frac{SurfCel3}{C3}$$

De cette manière, les condensateurs C1, C2, C3 se chargent à la même vitesse lorsque les cellules photovoltaïques sont éclairées de la même manière.

Selon l'invention, les surfaces et les formes des cellules photovoltaïques sont choisies de manière à ce que lorsqu'un doigt ou un objet est posé sur le dispositif, celui-ci recouvre une surface suffisante de la cellule photovoltaïque de détection Cel2 et ne recouvre pas ou peu les surfaces des cellules photovoltaïque de référence Cel1, Cel3 adjacentes. De cette manière, l'énergie E générée par la cellule photovoltaïque de détection pour charger son condensateur C2 (figure 2B) sera faible en comparaison de celles générées par les cellules photovoltaïques de référence Cel1, Cel3 pour charger leurs condensateurs C1, C3 respectifs.

Ainsi, sur les figures 1 et 2A à 2D, les trois cellules photovoltaïques Cel1, Cel2, Cel3 sont par exemple agencées sous la forme de trois bandes rectangulaires adjacentes recouvrant une surface supérieure, préférentiellement toute la surface supérieure, de la tête 10 du dispositif 1 de commande. Les trois bandes sont disposées de manière adjacente suivant un axe (X) de direction perpendiculaire au plan vertical d'approche du doigt ou de l'objet sur la surface de la tête du dispositif. De préférence, la cellule photovoltaïque de détection Cel2 est positionnée entre les deux cellules photovoltaïques de référence Cel1, Cel3. Grâce à cet agencement des cellules, le dispositif peut discriminer les ombres parasites d'un doigt ou d'un objet volontairement posé sur la cellule photovoltaïque de détection Cel2, comme représenté sur les figures 2A à 2D. Sur la figure 2A, les trois cellules photovoltaïques Cel1, Cel2, Cel3 sont uniformément éclairées. Sur la figure 2B, un doigt ou un objet est posé sur la cellule photovoltaïque de détection Cel2. Sur la figure 2C, une ombre parasite recouvre en totalité la cellule photovoltaïque de détection Cel2 et une cellule photovoltaïque de référence Cel3. Sur la figure 2D, une ombre parasite recouvre partiellement les trois cellules photovoltaïques Cel1, Cel2, Cel3. De plus, afin de favoriser le recouvrement de la surface de la cellule photovoltaïque de détection Cel2, la bande formée par celle-ci est par exemple plus mince dans la direction définie par l'axe (X) que celles formées par les cellules photovoltaïques de référence Cel1, Cel3.

Les condensateurs C1, C2, C3 sont connectés à leur cellule photovoltaïque Cel1, Cel2, Cel3 respective de sorte que le courant de charge traverse la cellule photovoltaïque Cel1, Cel2, Cel2 dans le sens de la hauteur, c'est-à-dire perpendiculairement à l'axe (X).

Le fonctionnement du dispositif consiste à regarder l'évolution des tensions V1, V2, V3 aux bornes de chacun des condensateurs C1, C2, C3 et à les comparer à un instant donné afin de pouvoir détecter ou non la présence d'un doigt ou d'un objet destiné à commander le dispositif 1. Si la tension V2 mesurée aux bornes du condensateur C2 associé à la cellule photovoltaïque de détection Cel2 est très inférieure aux tensions V1, V3 mesurées aux bornes des condensateurs C1, C3, la présence d'un doigt ou d'un objet sur le dispositif est détectée. Le critère de détection de la présence du doigt ou de l'objet est par exemple :

$$V2 < 30\% * V1 \text{ et } V2 < 30\% * V3$$

Bien entendu, des critères différents peuvent être appliqués.

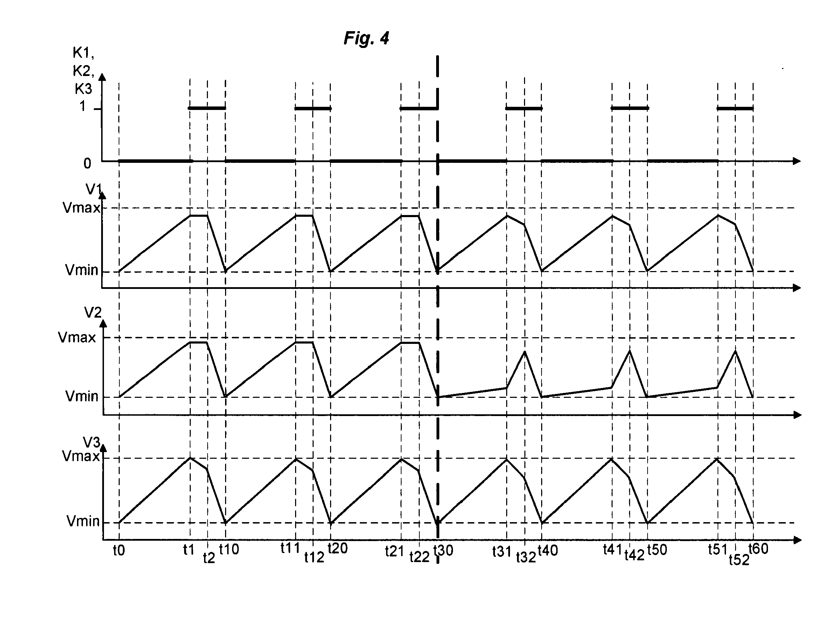

Plus précisément, le fonctionnement du dispositif est expliqué ci-dessous en référence aux diagrammes représentés en figure 4.

Présence d'aucun doigt et d'aucun objet parasite :

Entre t0 et t1 : Les interrupteurs K1, K2 et K3 sont ouverts. Les cellules photovoltaïques sont éclairées uniformément entraînant la charge des condensateurs C1, C2, C3 (figure 2A).

A t1 : Lorsque la tension aux bornes de l'un des trois condensateurs C1, C2, C3 a atteint un seuil maximal Vmax déterminé (sur la figure 4, la tension V3), les trois valeurs des tensions V1, V2, V3 sont comparées afin de détecter la présence d'un doigt. Les trois tensions V1, V2, V3 étant similaires, aucune présence de doigt n'est détectée. Simultanément ou juste après, le microprocesseur commande la fermeture des interrupteurs K1, K2 et K3.

Entre t1 et t2 : Les interrupteurs K1, K2, K3 restent fermés et les tensions s'équilibrent donc entre les trois condensateurs C1, C2, C3 (c'est-à-dire que V1=V2=V3).

A t2 : le microprocesseur active le convertisseur continu/continu pour transférer les charges des condensateurs C1, C2, C3 vers le condensateur principal C4.

Les instants t1 et t2 peuvent être confondus.

Entre t2 et t10 : les charges sont transférées progressivement dans le condensateur principal C4.

A t10 : lorsque les tensions V1, V2, V3 aux bornes des condensateurs atteignent un seuil minimal Vmin, le microprocesseur µP commande l'ouverture des interrupteurs K1, K2, K3.

Entre t10 et t20 et entre t20 et t30 : deux autres cycles sont reproduits de manière identique.

Présence d'un doigt ou d'un objet sur la cellule photovoltaïque de détection et d'aucun objet parasite :

A t31 : La tension V2 aux bornes du condensateur C2 associé à la cellule photovoltaïque de détection Cel2 est très faible en comparaison des tensions V1, V3 aux bornes des condensateurs C1, C3 associés aux cellules photovoltaïques de référence Cel1, Cel3. Si le critère V2<30%*V1 et V2<30%*V3 se vérifie alors le microprocesseur peut en déduire la présence d'un doigt ou d'un objet masquant la cellule photovoltaïque de détection (figure 2B). Le phénomène se répète en t41 et t51. L'envoi du signal électrique de commande S, S' peut être par exemple décidé par le microprocesseur µP lorsque le critère de détection se vérifie pendant un nombre de cycles successifs déterminé, c'est-à-dire pendant une durée déterminée.

Si l'éclairage général est faible, une amélioration consiste à modifier la différence entre le seuil minimal de tension Vmin et le seuil maximal de tension Vmax, en augmentant le seuil minimal Vmin et/ou en diminuant le seuil maximal Vmax afin de pouvoir augmenter le nombre de cycles et donc le nombre de mesures. Ces seuils minimal (Vmin) et maximal (Vmax) peuvent être par exemple réglés en fonction de la détection de l'éclairement général du dispositif, celle-ci dépendant de la lumière ambiante mais également des poussières éventuellement présentes sur la surface de la tête 10 du dispositif 1.

Dans une variante de réalisation, on peut prévoir de mesurer les tensions aux bornes des trois condensateurs C1, C2, C3 à des intervalles de temps réguliers, ce qui permet de ne pas avoir à surveiller en permanence les différentes tensions V1, V2, V3 par rapport aux seuils Vmax et Vmin et à ne pas se soucier du seuil de tension maximal Vmax pour déclencher les mesures.

**Revendications**

1. Dispositif de commande (1) d'un circuit électrique (2, 20) comprenant :

   - un capteur photovoltaïque (5) pour convertir une énergie lumineuse en une énergie électrique disponible pour le dispositif,
   - des moyens de détection (6) pour détecter la présence d'un doigt ou d'un objet sur le dispositif,
   - les moyens de détection (6) utilisant le capteur photovoltaïque (5) pour détecter la présence du doigt ou de l'objet sur le dispositif (1),
   - **caractérisé en ce que** :
   - le capteur photovoltaïque (5) comporte au moins une cellule photovoltaïque de détection (Cel2) et deux cellules photovoltaïques de référence (Cel1, Cel3), et **en ce que**
   - le dispositif de commande comporte en plus un condensateur (C2) monté en parallèle de la cellule photovoltaïque de détection (Cel2) et un condensateur (C1, C3) monté en parallèle de chaque cellule photovoltaïque de référence (Cel1, Cel3).

2. Dispositif selon la revendication 1, **caractérisé en ce que** chaque condensateur (C1, C2, C3) est monté en parallèle par rapport à sa cellule photovoltaïque (Cel1, Cel2, Cel3) respective.

3. Dispositif selon la revendication 1 ou 2, **caractérisé en ce que** le rapport entre la surface de la cellule photovoltaïque de détection (Cel2) et la capacité de son condensateur (C2) associé, est égal au rapport entre la surface de chaque cellule photovoltaïque de référence (Cel1, Cel3) et la capacité de leur condensateur (C1, C3) associé.

4. Dispositif selon l'une des revendications 1 à 3 **caractérisé en ce qu'**il comporte un condensateur principal (C4) destiné à être chargé par chaque condensateur (C1, C2, C3) associé à une cellule photovoltaïque (Cel1, Cel2, Cel3).

5. Dispositif selon la revendication 4, **caractérisé en ce qu'**il comporte un convertisseur continu/continu (DC/DC) commandé par des moyens de traitement ($\mu$P), reliant chaque ensemble constitué d'un condensateur (C1, C2, C3) et d'une cellule photovoltaïque (Cel1, Cel2, Cel3) au condensateur principal (C4).

6. Dispositif selon la revendication 5 **caractérisé en ce qu'**au moins deux ensembles sont connectés au convertisseur continu/continu (DC/DC) par l'intermédiaire d'un interrupteur (K1, K2, K3) commandé par les moyens de traitement ($\mu$P).

7. Dispositif selon la revendication 1 à 6, **caractérisé en ce que** la cellule photovoltaïque de détection (Cel2) et les deux cellules photovoltaïques de référence (Cel1, Cel3) sont agencées sous la forme de trois bandes adjacentes.

8. Dispositif selon la revendication 7, **caractérisé en ce que** les trois bandes sont disposées sur le dispositif de manière adjacente suivant un axe (X) déterminé perpendiculaire à un plan vertical d'approche du doigt ou de l'objet sur le dispositif (1).

9. Dispositif selon la revendication 8, **caractérisé en ce que** la cellule photovoltaïque de détection (Cel2) est placée entre les deux cellules photovoltaïques de référence (Cel1, Cel3).

10. Dispositif selon l'une des revendications 1 à 9, **caractérisé en ce que** le circuit électrique (2, 20) comporte un émetteur destiné à être alimenté par l'énergie électrique générée grâce au capteur photovoltaïque (5) et apte à communiquer par liaison sans fil avec un récepteur (4) distant.

11. Dispositif selon la revendication 10, **caractérisé en ce que** l'émetteur est intégré dans le dispositif (1).

12. Dispositif selon la revendication 10 ou 11, **caractérisé en ce que** le circuit électrique (2, 20) comporte un interrupteur apte à être commandé électriquement par le dispositif.

13. Procédé pour détecter la présence d'un doigt ou d'un objet sur un dispositif de commande d'un circuit électrique qui comporte :

   - au moins une cellule photovoltaïque de détection (Cel2) et deux cellules photovoltaïques de référence (Cel1, Cel3),

- un condensateur (C2) monté en parallèle de la cellule photovoltaïque de détection (Cel2) et un condensateur (C1, C3) monté en parallèle de chaque cellule photovoltaïque de référence (Cel1, Cel3),

le procédé étant **caractérisé en ce qu'**il comporte des étapes successives de :

- après une durée prédéterminée ou variable, mesure des tensions (V1, V2, V3) aux bornes des condensateurs (C1, C2, C3) associés aux cellules photovoltaïques (Cel1, Cel2, Cel3),
- comparaison des tensions (V1, V2, V3) entre elles pour valider ou non la présence d'un doigt sur le dispositif.

**14.** Procédé selon la revendication 13, **caractérisé en ce que** le dispositif de commande comporte un condensateur principal (C4) destiné à être chargé par chaque condensateur (C1, C2, C3) associé à une cellule photovoltaïque (Cel1, Cel2, Cel3) et un convertisseur continu/continu (DC/DC) commandé par des moyens de traitement ($\mu$P), reliant chaque ensemble constitué d'un condensateur (C1, C2, C3) et d'une cellule photovoltaïque (Cel1, Cel2, Cel3) au condensateur principal (C4) et **en ce que** le procédé comprend également une étape de transfert des charges accumulées dans les condensateurs vers le condensateur principal par activation du convertisseur continu/continu.

**15.** Procédé selon la revendication 14, **caractérisé en ce qu'**il comprend également une étape de désactivation du convertisseur continu/continu (DC/DC) lorsque les tensions (V1, V2, V3) aux bornes des condensateurs ont atteint un seuil minimal (Vmin) déterminé.

**16.** Procédé selon l'une des revendications 13 à 15, **caractérisé en ce que** la durée variable correspond à une durée au bout de laquelle une tension aux bornes de l'un des condensateurs a atteint un seuil maximal (Vmax) déterminé.

**17.** Procédé selon la revendication 15 ou 16, **caractérisé en ce que** le seuil minimal (Vmin) et/ou le seuil maximal (Vmax) sont variables en fonction de la détection de l'éclairement général du dispositif.

**18.** Procédé selon l'une des revendications 13 à 17, **caractérisé en ce que** si la tension (V2) aux bornes du condensateur (C2) associé à la cellule photovoltaïque de détection (Cel2) est très inférieure aux deux tensions (V1, V3) aux bornes du condensateur (C1, C3) associé à chaque cellule photovoltaïque de référence (Cel1, Cel3), la présence d'un doigt ou d'un objet est détectée.

**Claims**

**1.** Control device (1) of an electric circuit (2, 20) comprising:

- a photovoltaic sensor (5) for converting a light energy into an electrical energy available for the device,
- detection means (6) for detecting the presence of a finger or of an object on the device,
- the detection means (6) using the photovoltaic sensor (5) to detect the presence of the finger or of the object on the device (1),
- **characterized in that**:
- the photovoltaic sensor (5) includes at least one detection photovoltaic cell (Cel2) and two reference photovoltaic cells (Cel1, Cel3), and **in that**
- the control device also includes a capacitor (C2) mounted in parallel with the detection photovoltaic cell (Cel2) and a capacitor (C1, C3) mounted in parallel with each reference photovoltaic cell (Cel1, Cel3).

**2.** Device according to Claim 1, **characterized in that** each capacitor (C1, C2, C3) is mounted in parallel relative to its respective photovoltaic cell (Cel1, Cel2, Cel3).

**3.** Device according to Claim 1 or 2, **characterized in that** the ratio between the surface area of the detection photovoltaic cell (Cel2) and the capacitance of its associated capacitor (C2), is equal to the ratio between the surface area of each reference photovoltaic cell (Cel1, Cel3) and the capacitance of their associated capacitor (C1, C3).

**4.** Device according to one of Claims 1 to 3, **characterized in that** it includes a main capacitor (C4) intended to be charged by each capacitor (C1, C2, C3) associated with a photovoltaic cell (Cel1, Cel2, Cel3).

**5.** Device according to Claim 4, **characterized in that** it includes a DC/DC converter (DC/DC) controlled by processing

means ($\mu$P), linking each assembly consisting of a capacitor (C1, C2, C3) and a photovoltaic cell (Cell, Cel2, Cel3) to the main capacitor (C4).

6. Device according to Claim 5, **characterized in that** at least two assemblies are connected to the DC/DC converter (DC/DC) via a switch (K1, K2, K3) controlled by the processing means ($\mu$P).

7. Device according to Claims 1 to 6, **characterized in that** the detection photovoltaic cell (Cel2) and the two reference photovoltaic cells (Cell, Cel3) are arranged in the form of three adjacent strips.

8. Device according to Claim 7, **characterized in that** the three strips are arranged adjacently on the device along a determined axis (X) perpendicular to a vertical plane of approach of the finger or of the object on the device (1).

9. Device according to Claim 8, **characterized in that** the detection photovoltaic cell (Cel2) is placed between the two reference photovoltaic cells (Cell, Cel3).

10. Device according to one of Claims 1 to 9, **characterized in that** the electric circuit (2, 20) includes an emitter intended to be powered by the electrical energy generated by virtue of the photovoltaic sensor (5) and able to communicate by wireless link with a remote receiver (4).

11. Device according to Claim 10, **characterized in that** the emitter is incorporated in the device (1).

12. Device according to Claim 10 or 11, **characterized in that** the electric circuit (2, 20) includes a switch that can be electrically controlled by the device.

13. Method for detecting the presence of a finger or of an object on a control device of an electric circuit which comprises:

- at least one detection photovoltaic cell (Cel2) and two reference photovoltaic cells (Cell, Cel3),
- a capacitor (C2) mounted in parallel with the detection photovoltaic cell (Cel2) and a capacitor (C1, C3) mounted in parallel with each reference photovoltaic cell (Cell, Cel3), the method being **characterized in that** it comprises successive steps of:
- after a predetermined or variable time, measuring the voltages (V1, V2, V3) at the terminals of the capacitors (C1, C2, C3) associated with the photovoltaic cells (Cell, Cel2, Cel3),
- comparing the voltages (V1, V2, V3) with one another to confirm or not the presence of a finger on the device.

14. Method according to Claim 13, **characterized in that** the control device includes a main capacitor (C4) intended to be charged by each capacitor (C1, C2, C3) associated with a photovoltaic cell (Cell, Cel2, Cel3) and a DC/DC converter (DC/DC) controlled by processing means ($\mu$P), linking each assembly consisting of a capacitor (C1, C2, C3) and a photovoltaic cell (Cell, Cel2, Cel3) to the main capacitor (C4) and **in that** the method also comprises a step for transferring the charges accumulated in the capacitors to the main capacitor by activating the DC/DC converter.

15. Method according to Claim 14, **characterized in that** it also comprises a step for deactivating the DC/DC converter (DC/DC) when the voltages (V1, V2, V3) at the terminals of the capacitors have reached a determined minimum threshold (Vmin).

16. Method according to one of Claims 13 to 15, **characterized in that** the variable time corresponds to a time at the end of which a voltage at the terminals of one of the capacitors has reached a determined maximum threshold (Vmax).

17. Method according to Claim 15 or 16, **characterized in that** the minimum threshold (Vmin) and/or the maximum threshold (Vmax) are variable according to the detection of the general lighting of the device.

18. Method according to one of Claims 13 to 17, **characterized in that**, if the voltage (V2) at the terminals of the capacitor (C2) associated with the detection photovoltaic cell (Cel2) is very much lower than the two voltages (V1, V3) at the terminals of the capacitor (C1, C3) associated with each reference photovoltaic cell (Cell, Cel3), the presence of a finger or of an object is detected.

**Patentansprüche**

1. Steuervorrichtung (1) eines Stromkreises (2, 20), die enthält:

   - einen photovoltaischen Sensor (5), um eine Lichtenergie in eine elektrische Energie umzuwandeln, die der Vorrichtung zur Verfügung steht,
   - Erfassungseinrichtungen (6), um die Präsenz eines Fingers oder eines Objekts auf der Vorrichtung zu erfassen,
   - wobei die Erfassungseinrichtungen (6) den photovoltaischen Sensor (5) verwenden, um die Präsenz des Fingers oder des Objekts auf der Vorrichtung (1) zu erfassen,

   **dadurch gekennzeichnet, dass**:

   - der photovoltaische Sensor (5) mindestens eine photovoltaische Erfassungszelle (Cel2) und zwei photovoltaische Bezugszellen (Cel1, Cel3) aufweist, und dass
   - die Steuervorrichtung außerdem einen mit der photovoltaischen Erfassungszelle (Cel2) parallelgeschalteten Kondensator (C2) und einen mit jeder photovoltaischen Bezugszelle (Cel1, Cel3) parallelgeschalteten Kondensator (C1, C3) aufweist.

2. Vorrichtung nach Anspruch 1, **dadurch gekennzeichnet, dass** jeder Kondensator (C1, C2, C3) bezüglich seiner jeweiligen photovoltaischen Zelle (Cel1, Cel2, Cel3) parallelgeschaltet ist.

3. Vorrichtung nach Anspruch 1 oder 2, **dadurch gekennzeichnet, dass** das Verhältnis zwischen der Fläche der photovoltaischen Erfassungszelle (Cel2) und der Kapazität ihres zugeordneten Kondensators (C2) gleich dem Verhältnis zwischen der Fläche jeder photovoltaischen Bezugszelle (Cel1, Cel3) und der Kapazität ihres zugeordneten Kondensators (C1, C3) ist.

4. Vorrichtung nach einem der Ansprüche 1 bis 3, **dadurch gekennzeichnet, dass** sie einen Hauptkondensator (C4) aufweist, der dazu bestimmt ist, von jedem einer photovoltaischen Zelle (Cel1, Cel2, Cel3) zugeordneten Kondensator (C1, C2, C3) geladen zu werden.

5. Vorrichtung nach Anspruch 4, **dadurch gekennzeichnet, dass** sie einen von Verarbeitungseinrichtungen ($\mu$P) gesteuerten Gleichstrom-Gleichstrom-Wandler (DC/DC) aufweist, der jede aus einem Kondensator (C1, C2, C3) und einer photovoltaischen Zelle (Cel1, Cel2, Cel3) bestehende Einheit mit dem Hauptkondensator (C4) verbindet.

6. Vorrichtung nach Anspruch 5, **dadurch gekennzeichnet, dass** mindestens zwei Einheiten mit dem Gleichstrom-Gleichstrom-Wandler (DC/DC) über einen von den Verarbeitungseinrichtungen ($\mu$P) gesteuerten Schalter (K1, K2, K3) verbunden sind.

7. Vorrichtung nach Anspruch 1 bis 6, **dadurch gekennzeichnet, dass** die photovoltaische Erfassungszelle (Cel2) und die zwei photovoltaischen Bezugszellen (Cel1, Cel3) in Form von drei benachbarten Streifen angeordnet sind.

8. Vorrichtung nach Anspruch 7, **dadurch gekennzeichnet, dass** die drei Streifen auf der Vorrichtung gemäß einer bestimmten Achse (X) lotrecht zu einer senkrechten Ebene der Annäherung des Fingers oder des Objekts an die Vorrichtung (1) benachbart angeordnet sind.

9. Vorrichtung nach Anspruch 8, **dadurch gekennzeichnet, dass** die photovoltaische Erfassungszelle (Cel2) zwischen den zwei photovoltaischen Bezugszellen (Cel1, Cel3) angeordnet ist.

10. Vorrichtung nach einem der Ansprüche 1 bis 9, **dadurch gekennzeichnet, dass** der Stromkreis (2, 20) einen Emitter aufweist, der dazu bestimmt ist, mit der mit Hilfe des photovoltaischen Sensors (5) erzeugten elektrischen Energie gespeist zu werden, und durch drahtlose Verbindung mit einem fernen Empfänger (4) in Verbindung stehen kann.

11. Vorrichtung nach Anspruch 10, **dadurch gekennzeichnet, dass** der Emitter in die Vorrichtung (1) integriert ist.

12. Vorrichtung nach Anspruch 10 oder 11, **dadurch gekennzeichnet, dass** der Stromkreis (2, 20) einen Schalter aufweist, der elektrisch von der Vorrichtung gesteuert werden kann.

**13.** Verfahren zur Erfassung der Präsenz eines Fingers oder eines Objekts auf einer Vorrichtung zur Steuerung eines Stromkreises, die aufweist:

- mindestens eine photovoltaische Erfassungszelle (Cel2) und zwei photovoltaische Bezugszellen (Cel1, Cel3),
- einen mit der photovoltaischen Erfassungszelle (Cel2) parallelgeschalteten Kondensator (C2) und einen mit jeder photovoltaische Bezugszelle (Cel1, Cel3) parallelgeschalteten Kondensator (C1, C3),

wobei das Verfahren **dadurch gekennzeichnet ist, dass** es die aufeinanderfolgenden Schritte aufweist:

- nach einer vorbestimmten oder variablen Zeitdauer, Messung der Spannungen (V1, V2, V3) an den Klemmen der den photovoltaischen Zellen (Cel1, Cel2, Cel3) zugeordneten Kondensatoren (C1, C2, C3),
- Vergleich der Spannungen (V1, V2, V3) miteinander, um die Präsenz eines Fingers auf der Vorrichtung zu validieren oder nicht.

**14.** Verfahren nach Anspruch 13, **dadurch gekennzeichnet, dass** die Steuervorrichtung einen Hauptkondensator (C4), der dazu bestimmt ist, von jedem einer photovoltaischen Zelle (Cel1, Cel2, Cel3) zugeordneten Kondensator (C1, C2, C3) geladen zu werden, und einen von Verarbeitungseinrichtungen (μP) gesteuerten Gleichstrom-Gleichstrom-Wandler (DC/DC) aufweist, der jede aus einem Kondensator (C1, C2, C3) und einer photovoltaischen Zelle (Cel1, Cel2, Cel3) bestehende Einheit mit dem Hauptkondensator (C4) verbindet, und dass das Verfahren ebenfalls einen Schritt der Übertragung der in den Kondensatoren gesammelten Ladungen zum Hauptkondensator durch Aktivierung des Gleichstrom-Gleichstrom-Wandlers enthält.

**15.** Verfahren nach Anspruch 14, **dadurch gekennzeichnet, dass** es ebenfalls einen Schritt der Deaktivierung des Gleichstrom-Gleichstrom-Wandlers (DC/DC) enthält, wenn die Spannungen (V1, V2, V3) an den Klemmen der Kondensatoren eine bestimmte minimale Schwelle (Vmin) erreicht haben.

**16.** Verfahren nach einem der Ansprüche 13 bis 15, **dadurch gekennzeichnet, dass** die variable Dauer einer Dauer entspricht, an deren Ende eine Spannung an den Klemmen eines der Kondensatoren eine bestimmte maximale Schwelle (Vmax) erreicht hat.

**17.** Verfahren nach Anspruch 15 oder 16, **dadurch gekennzeichnet, dass** die minimale Schwelle (Vmin) und/oder die maximale Schwelle (Vmax) abhängig von der Erfassung der allgemeinen Beleuchtung der Vorrichtung variabel sind.

**18.** Verfahren nach einem der Ansprüche 13 bis 17, **dadurch gekennzeichnet, dass**, wenn die Spannung (V2) an den Klemmen des der photovoltaischen Erfassungszelle (Cel2) zugeordneten Kondensators (C2) sehr viel niedriger ist als die zwei Spannungen (V1, V3) an den Klemmen des jeder der photovoltaischen Bezugszelle (Cel1, Cel3) zugeordneten Kondensators (C1, C3), die Präsenz eines Fingers oder eines Objekts erfasst wird.

**Fig. 1**

**Fig. 2A**

**Fig. 2B**

**Fig. 2C**

**Fig. 2D**

Fig. 3

Fig. 4

**RÉFÉRENCES CITÉES DANS LA DESCRIPTION**

**Documents brevets cités dans la description**

- FR 2606912
- FR 2618242
- US 5251872 A